# EUROPEAN PATENT APPLICATION

(11) **EP 1 111 673 A1**
(43) Date of publication of application: **27.06.2001**
(21) Application number: 01200376.0
(22) Date of filing: 10.05.1995
(51) Int. Cl.: H01L 21/8247, H01L 21/8239

(54) **A method of manufacturing a MOS integrated circuit having components with different dielectrics**

(62) Divisional of application: 95830189.7
(71) Applicant: STMicroelectronics S.r.l., 20041 Agrate Brianza MI (IT)
(72) Inventor: Ghidini, Gabriella, 20131 Milano (IT); Clementi, Cesare, 21052 Busto Arsizio (Varese) (IT)
(74) Representative: Maggioni, Claudio

(57) **Abstract**

The method described provides for the formation of thin thermal oxide on areas of a silicon die intended for memory cells and other components of the peripheral circuits of the memory. To obtain the best dielectrics both for the memory cells and for the components of the peripheral circuits the method comprises a step for high-temperature nitriding of the oxide, a step for removing the nitrided oxide from the areas intended for the components of the peripheral circuits and a step for forming again a nitrided thermal oxide on the exposed areas.

## Description

The present invention relates to a method of forming structural elements, each comprising a dielectric and an electrically-conductive element thereon, in manufacturing an integrated circuit with memory cells and peripheral circuits on a monocrystalline silicon die, as known from EP-A-0 154 670 and defined in the preamble of claim 1.

A typical example of an integrated circuit with components of two somewhat different types is a non-volatile memory (an EPROM, an EEPROM or a "flash" memory) with the respective control circuits, that is, the reading, writing and, in the case of "flash" memories and EEPROMs, erasing circuits.

As is known, the cells of a non-volatile memory comprise, in their structures, a "floating" gate electrode separated from the silicon surface by a dielectric. The floating gate electrode is usually constituted by a thin, doped polycrystalline element and the dielectric is a thin layer (6-35nm) of silicon dioxide produced by oxidation of the silicon at high temperature (thermal oxide).

The control circuits of a matrix of memory cells and the other data-processing circuits, generally known as peripheral circuits, which may be integrated with the memory on the same silicon die contain components, such as MOSFET transistors and capacitors, which have structural elements similar to those of the memory cells. In particular, the bodies of the transistors and one electrode of each capacitor of the peripheral circuits are constituted by the silicon substrate, the gate electrodes of the transistors and the other electrode of each capacitor being constituted by an electrically-conductive element of metal or doped polycrystalline silicon.

Although the components of the first type, that is the memory cells, and the components of the second type, that is the transistors and the capacitors of the peripheral circuits, are structurally similar, it is not always possible or convenient to produce them by exactly the same operations. In particular, the thermal oxide used as the dielectric in the memory cells and in the peripheral circuits has to have different characteristics according to the function it performs in the two types of component. In fact, whereas in the transistors and in the capacitors of the peripheral circuits maximum electrical insulation between the electrodes separated by the dielectric is of essential importance, in the cells it is important for the oxide to be able to withstand movements of electrical charges within it, without deterioration, during the processes which occur during writing and during any erasure of the cells. Rapid degradation of the oxide results in a shorter operative life of the memory.

From US-A-4780424 and EP-A-0085551 it is known to form a silicon dioxide film on a silicon substrate and to subject this film to a nitriding treatment, particularly for obtaining a high-quality gate dielectric of a memory cell.

The general object of the present invention is to propose a method of the type defined at the beginning which can produce dielectrics of different qualities for the two different types of component of the integrated circuit.

This object is achieved, according to the invention, by the method defined and characterized in general in claim 1.

The invention and the advantages resulting therefrom will be explained further by the following description of some embodiments thereof, given by way of non-limiting example.

The method according to the invention can advantageously be put into practice to produce various types of integrated circuits with memories which may even differ greatly from one another structurally. The steps which distinguish them, however, are essentially the same for any type of integrated circuit.

One embodiment of the method provides for the initial silicon wafer (which, upon completion of the method, will be divided into dies each containing an integrated circuit) to be subjected, in an initial stage of its processing, in which areas intended for the memory cells and areas intended for various components of the peripheral circuits are defined, first of all to a normal high-temperature (750-950°C) oxidation treatment in an oven at atmospheric pressure in an oxidising atmosphere (H₂O or O₂/N₂) for sufficient time to form a layer of silicon dioxide (SiO₂) on the uncovered areas of the silicon wafer and then to a nitriding treatment at a temperature which may be equal to or a little greater than the oxidation temperature (750-1050°C) in a nitrous oxide (N₂O) atmosphere at atmospheric pressure for a period of between 5 and 60 minutes to produce a dielectric of the desired thickness (6-35 nm).

The steps described above produce a dielectric for the various components of the peripheral circuits which differs to a more or less marked extent from the normally preferred dielectric which is constituted by non-nitrided silicon dioxide. In order to improve the quality of this dielectric, it was attempted to remove completely the nitrided oxide formed on the areas intended for the components of the peripheral circuits and to subject the wafer to a new oxidation treatment.

It was found, predictably, that this treatment did not modify the good quality of the dielectric of the cells but also, completely unexpectedly, that it did not provide a good dielectric for the other components. The explanation for this result is still being investigated. It is clear, however, that the nitriding treatment produces undesired effects on the oxidised surface of the silicon which remain even after the layer of nitrided oxide has been removed.

According to the method of the invention, all of the uncovered areas of the silicon wafer are first oxidised and are then nitrided as described above, with a subsequent deposition of electrically-conductive material. Before the method is continued, the nitrided oxide is removed, preferably by chemical etching, after the removal of the overlying electrically-conductive material from the areas intended for the components of the peripheral circuits, and the wafer is subjected to further oxidation by a normal treatment and to a further nitriding treatment exactly the same as the previous one. Thus not only is it possible to produce, for the components of the peripheral circuits, oxide of a different thickness from that of the cells, if required, but, surprisingly, to produce a dielectric of a quality comparable with that of simple non-nitrided thermal oxide, thus producing not only memory cells of optimal quality, but also transistors and capacitors for the peripheral circuits with characteristics practically the same as those obtainable by a conventional process. It has in fact been found that the dielectric of the peripheral circuits has a greater resistance to the "stress" due to the injection of hot electrons.

A method according to the invention for the manufacture of an integrated circuit comprising a non-volatile, programmable and erasable memory, for example of the type known as a "flash" memory, and peripheral circuits for controlling the memory will now be described briefly.

The steps, carried out on a p-type monocrystalline silicon wafer are as follows:
- the formation of n-type regions (n-wells) and p-type regions (p-tubs),
- the formation of active areas insulated from one another by thick oxide (field oxide) produced by the known technique for the selective oxidation of the silicon,
- brief thermal oxidation of the active areas, followed by removal of the oxide formed to re-establish the crystalline surface characteristics of the silicon on the active areas,
- the formation of thermal oxide, followed by nitriding according to the steps described above,
- the deposition of a polycrystalline silicon layer to constitute the floating gate electrodes of the memory cells,
- the formation, on the polycrystalline silicon layer, of a dielectric, so-called "interpoly" layer, constituted by silicon dioxide alone or by a succession of layers comprising silicon dioxide and silicon nitride,
- the removal of the "interpoly" dielectric, of the polycrystalline silicon, and of the nitrided thermal oxide from the areas intended for the components of the peripheral circuits,
- the formation of thermal oxide in one or more operational steps, possibly comprising an intermediate step for the complete removal of the oxide from some of the areas intended for the components of the peripheral circuits, followed by nitriding,
- the deposition of a layer of polycrystalline silicon and a layer of metallic silicide,
- the definition of the gate structures of the memory cells and of the transistors of the peripheral circuits,
- the doping of the source and drain regions of the memory cells and of the transistors by implantation,
- the deposition of a layer of dielectric and the opening of windows therein for the contacts with doped regions and electrodes,
- the deposition of a metallic layer and the definition thereof to form the necessary circuit interconnections between the cells and the components,
- the deposition of a dielectric insulation layer and final passivation.

According to a variant of the method described above, the "interpoly" dielectric is formed by growth on the polycrystalline silicon intended for the floating gate electrodes during the "re-oxidation" step following the removal of the first thermal oxide from the areas intended for the components of the peripheral circuits.

Amongst the various integrated circuits which can advantageously be produced by the method according to the invention, it is worth mentioning, in particular, those which contain dynamic memories (DRAMs), with the respective reading/writing circuits. In this case, the process differs from that described above essentially in that the steps for the formation of the "interpoly" dielectric are omitted and the electrically-conductive layers of material constituted by polycrystalline silicon and metallic silicide serve to form not only the gate electrodes of the transistors of the peripheral circuits, but also the gate electrodes of the memory cells.

Although only some embodiments of the invention have been described, clearly many variants and modifications are possible within the scope of the same inventive concept. For example, the removal of the thermal oxide may be carried out by a dry method (RIE) instead of by chemical etching in a wet solution and the nitriding could be carried out in an atmosphere containing nitrogen compounds other than nitrous oxide, for example, NO or NH₃, possibly mixed with other gases, for example Ar. Moreover, both the thin-oxide-forming process and the nitriding process, or solely the nitriding process, could be carried out in RPT (rapid thermal process) ovens.

## Claims

1. A method of forming structural elements, each comprising a dielectric and an electrically-conductive element thereon, in manufacturing an integrated circuit with memory cells and peripheral circuits on a monocrystalline silicon die, said memory cells and peripheral circuits comprising structural elements having dielectrics of different characteristics in contact with the silicon die, the method comprising steps for the formation of first and second dielectrics comprising high-temperature treatments in an oxidising atmosphere to form silicon dioxide on areas of the die intended for the memory cells and peripheral circuits, steps for nitriding said silicon dioxide at least on some areas of said areas and steps for the formation of electrically-conductive material on the first and second dielectrics,
characterized in that it comprises
a first oxidation step comprising at least one high-temperature treatment in an oxidising atmosphere,
a high-temperature nitriding step,
a step for the removal of the silicon dioxide from the areas intended for the peripheral circuits,
a re-oxidation step comprising at least one high-temperature treatment in an oxidising atmosphere, and
a further high-temperature nitriding step.

2. A method according to claim 1, in which the formation of electrically-conductive material comprises a step for the deposition of polycrystalline silicon before the removal step,
the method further comprising a step, before the latter removal, for the removal of polycrystalline silicon at least from the areas intended for the peripheral circuits and in which the formation of electrically-conductive material comprises a further step for the deposition of polycrystalline silicon followed by a step for the selective removal thereof to form electrically-conductive elements on the areas intended for the memory cells and peripheral circuits.

3. A method according to claim 2, in which the step for the selective removal of the polycrystalline silicon also comprises the formation of electrically-conductive elements on the areas intended for the memory cells.

4. A method according to any of the preceding claims, in which the high-temperature nitriding step is carried out in an atmosphere containing nitrous oxide (N20) at a temperature of between 750 and 1050°C.
